# EUROPÄISCHE PATENTANMELDUNG

(11) **EP 2 592 697 A1**
(43) Veröffentlichungstag der Anmeldung: **15.05.2013**
(21) Anmeldenummer: 12187742.7
(22) Anmeldetag: 09.10.2012
(51) Int. Cl.: H01R 12/58, H05K 3/36

(54) **Elektrischer Verbinder**

(30) Priorität: 11.11.2011 DE 202011051937 U
(71) Anmelder: SUMIDA flexible connections GmbH, 01454 Radeberg (DE)
(72) Erfinder: Oßwald, Ralf, 01917 Kamenz (DE); Schiefer, Thomas, 01159 Dresden (DE)
(74) Vertreter: Carlsohn, Alexander

(57) **Zusammenfassung**

Die Erfindung betrifft einen elektrischer Verbinder, der insbesondere zum Verbinden von Leiterplatten geeignet ist, wobei der Verbinder (1) mehrere voneinander beabstandete Leiter (2) aufweist, die in ein elektrisch isolierendes Material unter Ausbildung einer Isolationszone (3), in der die Leiter (2) parallel zueinander verlaufen, eingebettet sind und an ihren Enden jeweils mit einem freiliegenden Abschnitt (5) über die Querkanten (4) der Isolationszone (3) hinausragen. Dabei ist vorgesehen, dass zumindest an einer Querkante (4) der Isolationszone (3) die freiliegenden Abschnitte (5) eines Teils der Leiter (2) oder aller Leiter (2) abgewinkelt sind.

## Beschreibung

Die Erfindung betrifft einen elektrischen Verbinder, der insbesondere zum elektrischen Verbinden von Leiterplatten geeignet ist.

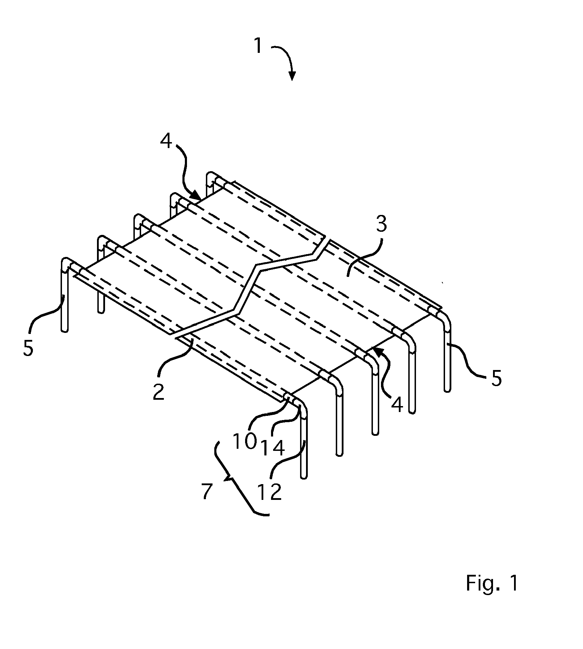

Zum Verbinden zweier Leiterplatten sind elektrische Verbinder erforderlich, die den Stromfluss zwischen den Leiterbahnen der einen Leiterplatte und den Leiterbahnen der anderen Leiterplatte ermöglichen können. Ein derartiger elektrischer Verbinder ist aus der DE-A-10 2005 056 147 der Sumida flexible connections GmbH bekannt, der auch als SMD-Verbinder (SMD: surface-mounted device) für die Oberflächenmontage (engl.: surface-mounted technology, SMT) eingesetzt werden kann. Gemäß der dortigen Figur 1 umfasst der elektrische Verbinder ein Flachbandkabel, an dessen isolationsfreien Enden z-förmige Leiterenden ausgebildet sind. Der äußere Schenkel der z-förmigen Leiterenden wird in Kontakt mit der Leiterbahn einer Leiterplatte gebracht. An beiden isolationsfreien Abschnitten können Fixierungselemente mit Metall- oder Kunststoffstiften vorgesehen sein, die in komplementäre Öffnungen eingeführt werden, die in der Leiterplatte ausgebildet sind, und dort über eine Schnappverbindung festgehalten werden. Auf diese Weise werden die Leiterenden auf der Leiterplatte fixiert.

Eine Anpassung der elektrischen Verbinder an die veränderten Montagebedingungen und höheren Belastungen ist erforderlich, wenn sie beispielsweise für die Montage im Reflow-Verfahren geeignet sein sollen. Dabei werden die Leiterplatten und der elektrische Verbinder typischerweise kurzzeitig einer Temperatur von mehr als 200 °C ausgesetzt, um eine Lötverbindung zwischen den Leiterbahnen, den Leiterplatten und den Kontaktenden des elektrischen Verbinders herzustellen. Höhere Belastungen ergeben sich darüber hinaus auch bei der Montage der elektrischen Verbinder mittels Durchsteckmontage (engl.: through-hole technology, THT). Bei der THT-Montage werden bedrahtete elektronische Bauelemente eingesetzt. Im Gegensatz zur Oberflächenmontage weisen bei der Durchsteckmontage die Bauelemente Drahtanschlüsse auf, weshalb diese Bauelemente auch als bedrahtete Bauelemente bezeichnet werden. Die Drahtanschlüsse werden bei der Montage über Kontaktlöcher, die in der Leiterplatte ausgebildet sind, durch die Leiterplatte gesteckt und anschließend durch Löten, beispielsweise durch Reflow-Löten verbunden.

Aus DE-U-20 2010 013 738 der Sumida flexible connections GmbH ist ein elektrischer Verbinder bekannt, der zum Verbinden von Leiterplatten durch Reflow-Löten mittels der Durchsteckmontage geeignet ist. Der Verbinder weist mehrere parallele, voneinander beanstandete Leiter gleicher Länge und Fixierungselemente auf. Die Leiter sind in ein elektrisch isolierendes Material unter Ausbildung einer Isolationszone, in der die Leiter in einer Ebene verlaufen, eingebettet sind und mit ihren Enden über die Querkanten der Isolationszone hinausragen. Diese Enden weisen eine Krümmung oder Abwinklung in eine Richtung orthogonal zur der Ebene auf. Ferner sind beide Bereiche der Isolationszone, die an eine Querkante angrenzen, jeweils unter Ausbildung der Fixierungselemente mit einem Kunststoffmaterial ummantelt, wobei jedes Fixierungselement, bezogen auf die Ebene, einen U-förmigen Querschnitt aufweist. Die Schenkel des Fixierelementes erstrecken sich in der Ebene in Richtung der an der Querkante hinausragenden Enden, so dass diese zwischen den beiden Schenkeln liegen, und an den beiden äußeren Enden der Schenkel Positionierungsstifte ausgebildet sind, die sich orthogonal zu der Ebene und gleichsinnig zu den gekrümmten oder abgewinkelten Enden der Leiter erstrecken.

Aus DE-U-20 2011 050 653 der Sumida flexible connections GmbH ist ferner ein elektrischer Verbinder bekannt, der ohne Fixierungselemente auskommt. Dafür sind sogenannte Blindleiter vorgesehen, die an den Längskanten des Verbinders liegen. Die abgewinkelten Enden der Bildleiter sind kürzer als Enden die übrigen Leiter. Aus diesem Grunde können die Blindleiter zur Fixierung der Verbinder genutzt werden.

Es ist jedoch erforderlich, die bekannten elektrischen Verbinder weiter zu verbessern. Es ist insbesondere erforderlich, die Kosten für die Herstellung der elektrischen Verbinder zu reduzieren, ohne dabei deren Eignung für das Reflow-Löten mittels der Durchsteckmontage-Technik zu beeinträchtigen.

Aufgabe der Erfindung ist es, einen elektrischen Verbinder anzugeben, der insbesondere für das Verbinden von Leiterplatten mittels des Reflow-Lötens geeignet ist und dessen Herstellung mit verringerten Kosten verbunden ist. Darüber hinaus soll der elektrische Verbinder für eine Durchsteckmontage geeignet sein. Zudem soll der elektrische Verbinder flexibel zwischen den Leiterplatten wirken. Toleranzen und Bewegungen zwischen den Leiterplattenebenen sollen ausgeglichen werden.

Diese Aufgabe wird durch die Merkmale des Anspruchs 1 gelöst. Zweckmäßige Ausgestaltungen der Erfindung ergeben sich aus den Merkmalen der Unteransprüche.

Nach Maßgabe der Erfindung ist ein elektrischer Verbinder vorgesehen, der insbesondere zum Verbinden von Leiterplatten geeignet ist, wobei der Verbinder mehrere voneinander beabstandete Leiter aufweist, die in ein elektrisch isolierendes Material unter Ausbildung einer Isolationszone, in der die Leiter parallel zueinander verlaufen, eingebettet sind und an ihren Enden jeweils mit einem freiliegenden Abschnitt über die Querkanten der Isolationszone hinausragen, wobei zumindest an einer Querkante der Isolationszone die freiliegenden Abschnitte eines Teils der Leiter oder aller Leiter abgewinkelt sind.

Es ist bevorzugt, dass alle freiliegenden Abschnitte, die an einer Querkante der Isolationszone abgewinkelt sind, die gleiche Länge aufweisen.

Vorzugsweise weisen die freiliegenden Abschnitte der Leiter unabhängig voneinander eine der folgenden Grundformen auf:
- eine erste Grundform, bei der der freiliegende Abschnitt ohne Richtungsänderung aus der Isolationszone an der Querkante austritt;
- eine zweite Grundform, bei der der freiliegenden Abschnitt ein erstes Segment, das ohne Richtungsänderung aus der Isolationszone an der Querkante austritt, und ein zweites Segment, das zu dem ersten Segment in einem Winkel verläuft, aufweist;
- eine dritte Grundform, bei der der freiliegenden Abschnitt ein erstes Segment, das ohne Richtungsänderung aus der Isolationszone an der Querkante austritt, und ein zweites Segment, das zu dem ersten Segment in einem Winkel verläuft, aufweist, wobei das erste Segment der dritten Grundform länger als das erste Segment der zweiten Grundform ist; oder
- eine vierte Grundform, bei der der freiliegenden Abschnitt ein erstes Segment, das ohne Richtungsänderung aus der Isolationszone an der Querkante austritt, ein zweites Segment, das zu dem ersten Segment in einem Winkel verläuft, und ein drittes Segment, das parallel zu dem ersten Segment verläuft, aufweist.

Bei der zweiten und vierten Grundform kann die Länge des ersten Segmentes nahe null sein.

Die zweite, dritte und vierte Grundform sind abgewinkelte Grundformen. Die erste Grundform ist eine nicht-abgewinkelte Grundform.

Vorzugsweise weisen an einer oder beiden Querkanten die freiliegenden Abschnitte aller Leiter die zweite, dritte oder vierte Grundform auf. In einer Ausführungsform weisen an beiden Querkanten der Isolationszone die freiliegenden Abschnitte aller Leiter die zweite Grundform auf.

In einer Ausführungsform der Erfindung sind an einer Querkante alternierend freiliegende Abschnitte der zweiten Grundform und freiliegende Abschnitte der dritten Grundform vorgesehen.

In einer anderen Ausführungsform sind an einer Querkante alternierend freiliegende Abschnitte der ersten Grundform und freiliegende Abschnitte der vierten Grundform vorgesehen. Diese Ausführungsform ist insbesondere zum elektrischen Verbinden zweier Leiterplatten geeignet, die parallel zu einander angeordnet sind. Dabei ist eine Flächenseite einer ersten Leiterplatte einer Flächenseite einer zweiten Leiterplatte zugewandt. Die Leiterplatten können fluchtend zueinander angeordnet sein. Die Ausführungsform ermöglicht es, den elektrischen Verbinder im Wesentlichen senkrecht zu einer Flächenseite einer Leiterplatte anzuordnen. Der Ausdruck "senkrecht" bezieht sich dabei auf die Längsachse der Leiter innerhalb der Isolationszone.

Vorzugsweise weisen die freiliegenden Abschnitte eines Leiters an beiden Querkanten dieselbe Grundform auf, dies ist jedoch nicht erforderlich. Vielmehr kann bei einem Leiter der freiliegende Abschnitt an der einen Querkante eine der vier Grundformen und unabhängig davon der freiliegende Abschnitt des Leiters an der anderen Querkante eine der vier Grundformen aufweisen, wobei die Grundform dieses freiliegenden Abschnittes dieselbe oder eine andere Grundform als die des ersten freiliegenden Abschnittes sein kann.

Zweckmäßigerweise sind die freiliegenden Abschnitte der Leiter zumindest an ihren Enden zylinderförmig oder hohlzylinderförmig ausgebildet.

Der erfindungsgemäße elektrische Verbinder ermöglicht es, auf gesonderte Fixierungselemente oder Blindleiter zu verzichten. Aus diesem Grund sind alle Leiter des erfindungsgemäßen Verbinders zur Stromführung bestimmt und damit beim Einsatz der elektrischen Verbinder zur Verbindung von Leiterplatten stromführende Leiter.

Vorzugsweise weist der elektrische Verbinder zumindest drei Leiter, stärker bevorzugt zumindest fünf Leiter auf. Innerhalb der Isolationszone verlaufen die Leiter vorzugsweise in einer Ebene. Das erste Segment und das zweite Segment eines freiliegenden Abschnittes sind vorzugsweise über ein erstes gekrümmtes Segment miteinander verbunden. Das zweite Segment und das erste Segment eines freiliegenden Abschnittes sind vorzugsweise über ein zweites gekrümmtes Segment miteinander verbunden.

Das erste gekrümmte Segment hat, sofern vorhanden, vorzugsweise bei allen freiliegenden Abschnitten die gleiche Länge und/oder den gleichen Krümmungsradius, und zwar besonders bevorzugt auch dann, wenn freiliegenden Abschnitte der zweiten und freiliegende Abschnitte der dritten Grundform vorgesehen sind. Das zweite gekrümmte Segment hat, sofern vorhanden, vorzugsweise bei allen freiliegenden Abschnitten die gleiche Länge und/oder den gleichen Krümmungsradius. Vorzugsweise haben die zweiten Segmente der zweiten Grundform dieselbe Länge wie die zweiten Segmente der ersten Grundform.

Die freiliegenden Abschnitte einer Grundform sollten jeweils dieselben Abmessungen und Winkel aufweisen. Die im Winkel zu ersten Segmenten vorlaufenden zweiten Segmente sollten sich an ein und derselben Querkante, zweckmäßigerweise an beiden Querkanten, in dieselbe Richtung erstrecken.

Zweckmäßigerweise verläuft bei der zweiten und/oder dritten Grundform das zweite Segment in einem Winkel von 90° zum ersten Segment.

Das erste Segment der dritten Grundform soll länger als das erste Segment der zweiten Grundform sein. Bevorzugt ist das erste Segment der dritten Grundform wenigstens 2mal, stärker bevorzugt 5mal, noch stärker bevorzugt 10mal und besonders bevorzugt wenigstens 20mal solang wie das erste Segment der zweiten Grundform. Hingegen sind die zweiten Segmente der zweiten Grundform und die zweiten Segmente der dritten Grundform vorzugsweise gleichlang.

Der erfindungsgemäße elektrische Verbinder ist zur automatischen Montage, beispielsweise mittels der Durchsteckmontage und des Reflow-Lötens geeignet. Zur automatischen Montage eines erfindungsgemäßen elektrischen Verbinders kann folgendermaßen vorgegangen werden:
(i) Zunächst werden die Bohrungen in der Leiterplatte, in die die Enden der freiliegenden Abschnitte der Leiter eingeführt werden sollen, mittels Siebdruck mit der Lötpaste befüllt. Die Bohrungen sind komplementär zu den Enden der freiliegenden Abschnitte, die der nächstliegenden Querkante der Isolationszone abgewandt sind.
(ii) Mittels eines Automaten wird der erfindungsgemäße Verbinder so eingesetzt, dass die Enden der freiliegenden Abschnitte in die mit Löstpaste gefüllten, komplentären Bohrungen in der Leiterplatte gelangen.
(iii) Schließlich werden im Reflow-Ofen die Leiterenden des erfindungsgemäßen Verbinders mit den Leiterbahnen der Leiterplatte verlötet.

Die Leiter des erfindungsgemäßen Verbinders können Kupferleiter, Aluminiumleiter oder Leiter aus einem anderen Material, das den elektrischen Strom leitet, sein. Bevorzugt sind die Leiter Kupferleiter. Die Leiter verlaufen innerhalb der Isolationszone parallel zueinander und sind vorzugsweise voneinander gleichmäßig beabstandet. Die über die Querkanten der Isolationszone hinausragenden Abschnitte der Leiter können, insgesamt oder zumindest an ihren Enden, unabhängig voneinander zylinder- oder hohlzylinderförmig sein.

Die Leiter können Runddrähte oder Flachleiter oder Kombinationen aus Runddrähten und Flachleitern sein. Sind die Leiter Flachleiter, so können die freiliegenden Abschnitte zur Ausbildung der Zylinder- oder Hohlzylinderform gecrimpt sein.

Bei einer Kombination aus Runddrähten und Flachleitern weisen die Leiter beispielsweise jeweils einen mittleren flachen Abschnitt auf, der in der Isolationszone angeordnet ist. An die beiden Stirnseiten des flachen Abschnittes grenzt jeweils ein Übergangsabschnitt an, der in einen zylinder- oder hohlzylinderförmigen Abschnitt übergeht. Auch die Übergangsabschnitte sollten sich in der Isolationszone befinden. Zweckmäßigerweise befindet sich ein Teil der zylinder- oder hohlzylinderförmigen Abschnitte in der Isolationszone. Der Ausdruck "flacher Abschnitt" bezieht sich auf einen Abschnitt eines Leiters mit im Wesentlichen rechteckigem Querschnitt, wobei die Höhe des Leiters in diesem Abschnitt geringer als die Breite des Leiters in diesem Abschnitt ist. Die Kanten des Leiters in diesem Abschnitt können abgerundet sein. Die Höhe des flachen Abschnittes kann beispielsweise 0,2 mm oder weniger, bevorzugt 0,1 mm oder weniger betragen; die Breite des flachen Abschnittes kann beispielsweise 0,5 bis 2 mm betragen.

Unter dem Begriff "Querkante" der Isolationszone wird hier eine Kante der Isolationszone verstanden, die quer zur Längsrichtung der Leiter verläuft.

Die Isolationszone hat vorzugsweise einen im Wesentlichen rechteckigen Querschnitt. Die Längs- und/oder Querkanten der Isolationszone können abgerundet sein. Die Flachseiten der Isolationszone müssen nicht vollkommen eben sein, sondern komplementär zu den Konturen der Leiter, soweit diese innerhalb der Isolationszone verlaufen, geformt sein.

Die Leiter können in zwei Kunststofffolien unter Bildung einer Sandwichstruktur eingebettet sein. Diese Sandwichstruktur bildet dann die Isolationszone der Vorrichtung. Innerhalb der Sandwichstruktur können die Leiter in einer Ebene verlaufen. Die beiden Kunststofffolien können miteinander verklebt sein. Ebenso kann jede andere Weise zur Herstellung der Sandwichstruktur verwendet werden, beispielsweise ein Laminierungsverfahren. Die Kunststofffolien können beispielsweise aus Polyethylen, Polytetrafluorethylen, Polyamid, Polyurethan oder einem anderen elektrisch isolierenden Kunststoff bestehen. Die Kunststofffolien können transparent sein.

Nach Maßgabe der Erfindung ist ferner die Verwendung eines erfindungsgemäßen elektrischen Verbinders zum elektrischen Verbinden von Leiterplatten vorgesehen, wobei die Leiterplatten mit ihren Flächenseiten parallel zueinander angeordnet sind. Es kann vorgesehen sein, dass das oben angegebene Verfahren zur automatischen Montage jeweils gesondert für jede Festplatte vorgenommen wird. Im Fall der Verbindung zweiter Leiterplatten mittels eines erfindungsgemäßen Verbinders können die Schritte (i) bis (iii) dann für jede Festplatte gesondert, also jeweils zweimal vorgesehen sein.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine perspektivische Darstellung einer ersten Ausführungsform eines erfindungsgemäßen elektrischen Verbinders;
- Fig. 2: eine perspektivische Darstellung einer zweiten Ausführungsform eines erfindungsgemäßen elektrischen Verbinders;
- Fig. 3: eine perspektivische Darstellung einer dritten Ausführungsform eines erfindungsgemäßen elektrischen Verbinders;
- Fig. 4: eine perspektivische Darstellung einer Leiterplatte mit einer Teilansicht der dritten Ausführungsform des elektrischen Verbinders;
- Fig. 5: eine Draufsicht einer vierten Ausführungsform eines erfindungsgemäßen elektrischen Verbinders;
- Fig. 6: einen Blick auf eine Querkante der in Fig. 5 gezeigten Ausführungsform,
- Fig. 7: eine Schnittdarstellung der in Fig. 5 gezeigten Ausführungsform entlang Schnittlinie A--A; und
- Fig. 8: einen Blick auf eine Längskante der in Fig. 5 gezeigten Ausführungsform.

Die in den Figuren 1 bis 3 gezeigten Ausführungsformen erfindungsgemäßer elektrischer Verbinder 1 weisem jeweils mehrere parallele, voneinander beabstandete Leiter 2 auf. Die Leiter 2 sind Runddrähte. Die Leiter 2 sind in ein elektrisch isolierendes Material eingebettet, wodurch eine Isolationszone 3 erhalten wird. In Figuren 1 bis 3 sind die Konturen der Leiter 2 innerhalb der Isolationszone 3 zu erkennen. Abgesehen davon ist die Isolationszone 3 flach. Die Isolationszone 3 wird erhalten, indem die Leiter 2 zwischen zwei Kunststofffolien sandwichartig eingelegt werden. Die Leiter 2 treten an den Querkanten 4 der Isolationszone 3 aus dieser aus. Außerhalb der Isolationszone 3 weisen die Leiter 2 freiliegende Abschnitte 5 auf.

In den gezeigten Ausführungsformen weisen die freiliegenden Abschnitte 5 der Leiter 2 jeweils eine der folgenden Grundformen auf:
- eine erste Grundform 6, bei der der freiliegende Abschnitt 5 ohne Richtungsänderung aus der Isolationszone 3 an der Querkante 4 austritt;
- eine zweite Grundform 7, bei der der freiliegenden Abschnitt 5 ein erstes Segment 10, das ohne Richtungsänderung aus der Isolationszone 3 an der Querkante 4 austritt, und ein zweites Segment 11, das orthogonal zu dem ersten Segment 10 verläuft und mit diesem über ein erstes gekrümmtes Segment 14 verbunden ist, aufweist;
- eine dritte Grundform 8, bei der der freiliegenden Abschnitt 5 ein erstes Segment 10', das ohne Richtungsänderung aus der Isolationszone 3 an der Querkante 4 austritt, und ein zweites Segment 11, das orthogonal zu dem ersten Segment 10' verläuft und mit diesem über ein erstes gekrümmtes Segment 14 verbunden ist, aufweist, wobei das erste Segment 10' der dritten Grundform 8 länger als das erste Segment 10 der zweiten Grundform 7 ist; oder
- eine vierte Grundform 9, bei der der freiliegenden Abschnitt 5 ein erstes Segment 10, das ohne Richtungsänderung aus der Isolationszone 3 an der Querkante austritt, ein zweites Segment 11, das orthogonal zu dem ersten Segment 10 verläuft und mit diesem über ein erstes gekrümmtes Segment 14 verbunden ist, und ein drittes Segment 12, das parallel zu dem ersten Segment verläuft und mit dem zweiten Segment über ein zweites gekrümmtes Segment 15 verbunden ist, aufweist.

In der in Fig. 1 gezeigten, ersten Ausführungsform des erfindungsgemäßen elektrischen Verbinders weisen alle freiliegenden Abschnitte 5 aller Leiter 2 die zweite Grundform 7 auf.

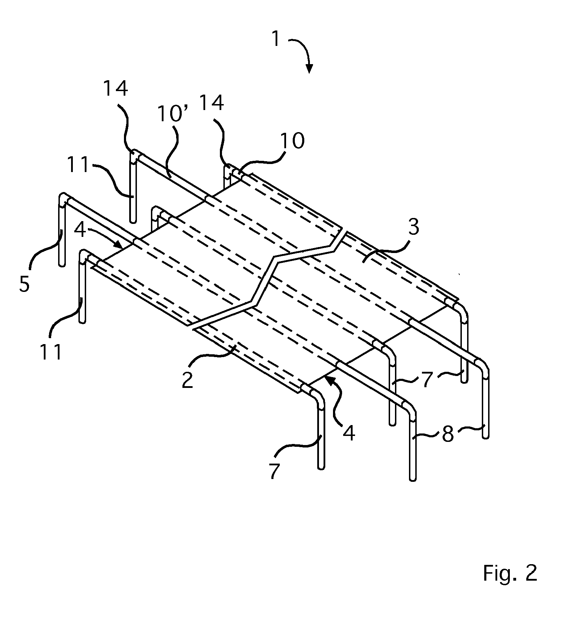

In der in Fig. 2 gezeigten, zweiten Ausführungsform weisen die freiliegenden Abschnitte 5 der Leiter 2 alternierend entweder die zweite Grundform 7 oder die dritte Grundform 8 auf, wobei die die freiliegenden Enden der außenliegenden Leiter 2 die zweite Grundform 7 aufweisen.

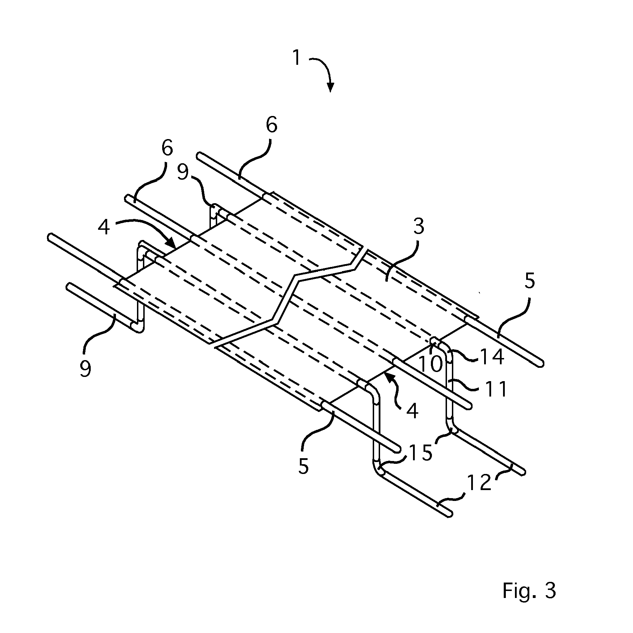

In der in Fig. 3 gezeigten, dritten Ausführungsform weisen die freiliegenden Abschnitte 5 der Leiter 2 alternierend entweder die erste Grundform 6 oder die vierte Grundform 9 auf, wobei die die freiliegenden Enden der außenliegenden Leiter 2 die erste Grundform 6 besitzen.

In den in den Figuren 1 bis 3 gezeigten Ausführungsformen weisen die freiliegenden Abschnitte 5 eines Leiters 2 an beiden Querkanten 4 der Isolationszone 3 jeweils dieselbe Grundform auf. Dies ist jedoch nicht erforderlich. Vielmehr kann ein Leiter an der anderen Querkante 4 auch einen freiliegenden Abschnitt 5 mit einer anderen der vier Grundformen aufweisen.

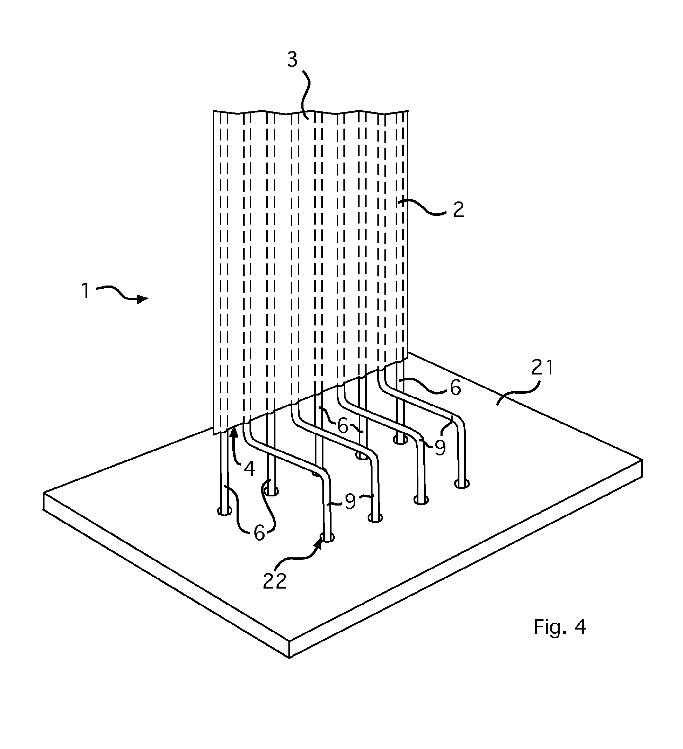

In Fig. 4 ist der in Fig. 3 gezeigte elektrische Verbinder 1 im Verhältnis zu einer Leiterplatte 21 gezeigt. Dabei sind die Enden der freiliegenden Abschnitte 5 an einer Stirnseite 4 der Isolationszone 3 in Bohrungen 22 eingesteckt. Die Bohrungen 22 sind komplementär zu den Enden der freiliegenden Abschnitte 5 in der Leiterplatte 21 ausgebildet. Zur Vereinfachung der Darstellung ist in Fig. 4 nur ein Teil des elektrischen Verbinders 1 dargestellt.

Weist der freiliegende Abschnitt jedes Leiters 2 des elektrischen Verbinders 1 an seiner nicht gezeigten Querkante die selbe Grundform (erste Grundform 6 oder vierte Grundform 9) auf, wie der freiliegende Abschnitt 5 des Leiters 2 an der gezeigten Querkante 4, so kann der elektrische Verbinder zur elektrischen Verbindung zweier Leiterplatten eingesetzt werden, die parallel zu einander angeordnet sind. Dabei ist eine Flächenseite der ersten Festplatte 21, beispielsweise ihre Oberseite, einer Flächenseite der zweiten Festplatte (nicht gezeigt), beispielsweise ihrer Unterseite, zugewandt. Insbesondere können die Leiterplatten, bezogen auf ihre Flächenseiten, fluchtend zueinander angeordnet sein. Wie in Fig. 4 gezeigt, ist der elektrische Verbinder 1 senkrecht zu der Flächenseite der Leiterplatte 21 angeordnet.

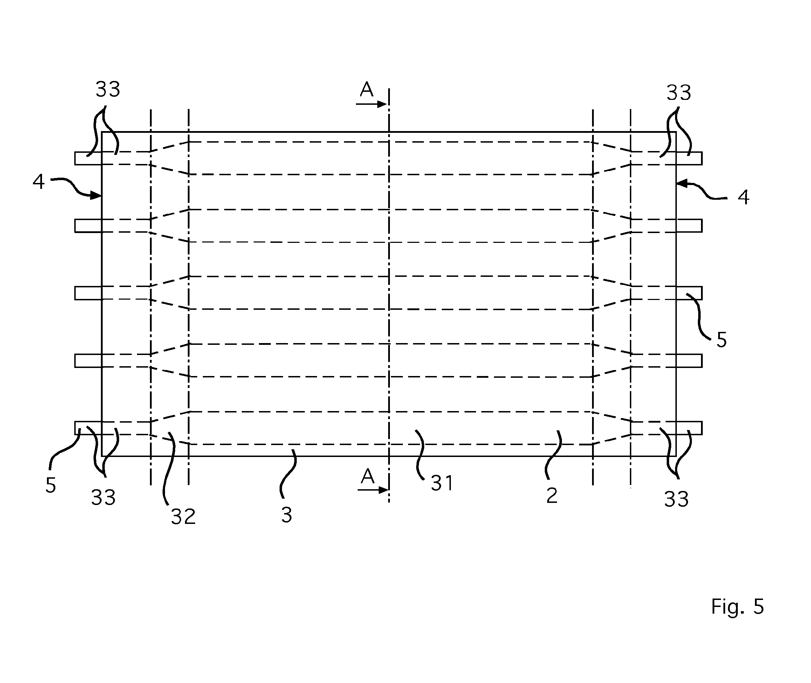

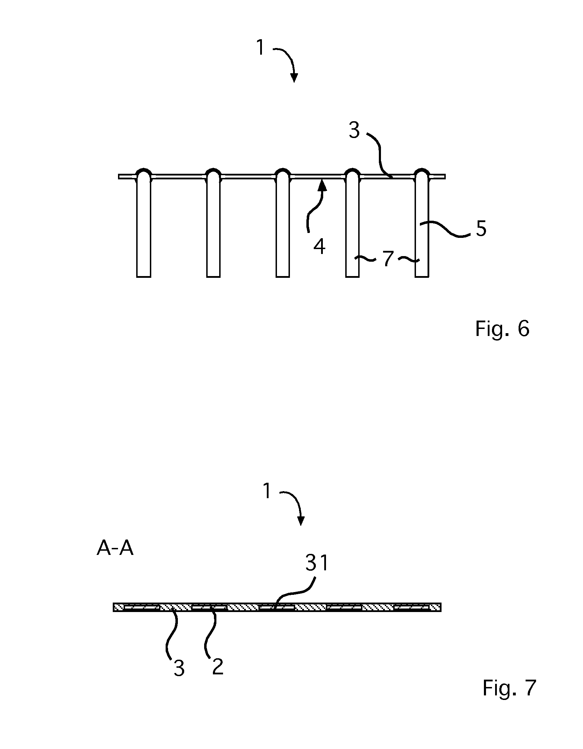

Die in den Figuren 5 bis 8 gezeigte vierte Ausführungsform eines erfindungsgemäßen elektrischen Verbinders 1 entspricht der ersten Ausführungsform, außer dass die Leiter 2 eine Kombination aus Flachleiter und Runddraht sind. Jeder Leiter 2 weist einen mittleren flachen Abschnitt 31 auf, der in der Isolationszone 3 angeordnet ist. An die beiden Stirnseiten des flachen Abschnittes 31 grenzt jeweils ein Übergangsabschnitt 32 an, der in einen zylinderförmigen Abschnitt 33 übergeht. Auch die Übergangsabschnitte 32 sowie der daran angrenzende erste Teil der zylinderförmigen Abschnitte 33 befinden sich in der Isolationszone 3. Der erste Teil des zylinderförmigen Abschnitts 33 erstreckt sich bis zur Querkante 4. Der sich dort anschließende zweite Teil des zylinderförmigen Abschnittes 33 ist ein freiliegender Abschnitt 5 des Leiters 2.

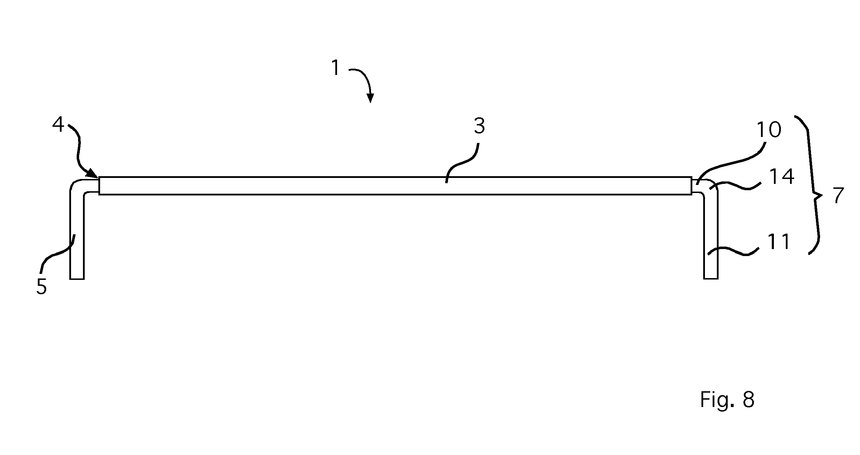

In den Figuren 5 bis 8 weisen die freiliegenden Abschnitte 5 die zweite Grundform 7 auf (siehe insbesondere Fig. 8). Selbstverständlich kann jeder freiliegende Abschnitt 5 auch eine andere Grundform aufweisen. Beispielsweise kann die in der vierten Ausführungsform vorgesehene Kombination aus Flachleiter und Runddraht auch bei der ersten, zweiten und dritten Ausführungsform eingesetzt werden.

### Bezugszeichenliste

- 1: Elektrischer Verbinder
- 2: Leiter
- 3: Isolationszone
- 4: Querkante
- 5: freiliegender Abschnitt
- 6: erste Grundform
- 7: zweite Grundform
- 8: dritte Grundform
- 9: vierte Grundform
- 10, 10': erstes Segment
- 11: zweites Segment
- 12: drittes Segment
- 14: erstes gekrümmtes Segment
- 15: zweites gekrümmtes Segment

- 21: Leiterplatte
- 22: Bohrung

- 31: flacher Abschnitt
- 32: Übergangsabschnitt
- 33: zylinderförmiger Abschnitt

## Patentansprüche

1. Elektrischer Verbinder, der insbesondere zum Verbinden von Leiterplatten geeignet ist, wobei der Verbinder (1) mehrere voneinander beabstandete Leiter (2) aufweist, die in ein elektrisch isolierendes Material unter Ausbildung einer Isolationszone (3), in der die Leiter (2) parallel zueinander verlaufen, eingebettet sind und an ihren Enden jeweils mit einem freiliegenden Abschnitt (5) über die Querkanten (4) der Isolationszone (3) hinausragen, **dadurch gekennzeichnet, dass** zumindest an einer Querkante (4) der Isolationszone (3) die freiliegenden Abschnitte (5) eines Teils der Leiter (2) oder aller Leiter (2) abgewinkelt sind.

2. Elektrischer Verbinder nach Anspruch 1, **dadurch gekennzeichnet, dass** alle freiliegenden Abschnitte, die an einer Querkante (4) der Isolationszone (3) abgewinkelt sind, die gleiche Länge aufweisen.

3. Elektrischer Verbinder nach Anspruch 1 oder Anspruch 2, **dadurch gekennzeichnet, dass** die freiliegenden Abschnitte (5) der Leiter (2) unabhängig voneinander eine der folgenden Grundformen (6, 7, 8, 9) aufweisen:
- eine erste Grundform (6), bei der der freiliegende Abschnitt (5) ohne Richtungsänderung aus der Isolationszone (3) an der Querkante (4) austritt;
- eine zweite Grundform (7), bei der der freiliegenden Abschnitt (5) ein erstes Segment (10), das ohne Richtungsänderung aus der Isolationszone (3) an der Querkante (4) austritt, und ein zweites Segment (11), das zu dem ersten Segment (10) in einem Winkel verläuft, aufweist;
- eine dritte Grundform (8), bei der der freiliegenden Abschnitt (5) ein erstes Segment (10'), das ohne Richtungsänderung aus der Isolationszone (3) an der Querkante (4) austritt, und ein zweites Segment (11), das zu dem ersten Segment (10') in einem Winkel verläuft, aufweist, wobei das erste Segment (10') der dritten Grundform (8) länger als das erste Segment (10) der zweiten Grundform (7) ist; oder
- eine vierte Grundform (9), bei der der freiliegenden Abschnitt (5) ein erstes Segment (10), das ohne Richtungsänderung aus der Isolationszone (3) an der Querkante (4) austritt, ein zweites Segment (11), das zu dem ersten Segment (10) in einem Winkel verläuft, und ein drittes Segment (12), das parallel zu dem ersten Segment (10) verläuft, aufweist.

4. Elektrischer Verbinder nach Anspruch 3, **dadurch gekennzeichnet, dass** an einer Querkante (4) die freiliegenden Abschnitte (5) aller Leiter (2) die zweite, dritte oder vierte Grundform (7, 8, 9) aufweisen.

5. Elektrischer Verbinder nach Anspruch 3 oder Anspruch 4, **dadurch gekennzeichnet, dass** an einer Querkante (4) alternierend freiliegende Abschnitte (5) der zweiten Grundform (7) und freiliegende Abschnitte (5) der dritten Grundform (8) vorgesehen sind.

6. Elektrischer Verbinder nach Anspruch 3, **dadurch gekennzeichnet, dass** an einer Querkante (4) alternierend freiliegende Abschnitte (5) der ersten Grundform (6) und freiliegende Abschnitte (5) der vierten Grundform (9) vorgesehen sind.

7. Elektrischer Verbinder nach einem der Ansprüche 3 bis 6, **dadurch gekennzeichnet, dass** die freiliegenden Abschnitte (5) eines Leiters (2) an beiden Querkanten (4) dieselbe Grundform (6, 7, 8, 9) aufweisen.

8. Elektrischer Verbinder nach einem der vorstehenden Ansprüche, **dadurch gekennzeichnet, dass** die freiliegenden Abschnitte (5) der Leiter (2) zumindest an ihren Enden zylinderförmig oder hohlzylinderförmig sind.

9. Elektrischer Verbinder nach einem der vorstehenden Ansprüche, **dadurch gekennzeichnet, dass** die Leiter (2) innerhalb der Isolationszone (3) Runddrähte und/oder Flachleiter und/oder Kombinationen aus Runddrähten und Flachleitern sind.

10. Elektrischer Verbinder nach einem der vorstehenden Ansprüche, **dadurch gekennzeichnet, dass** alle oder zumindest ein Leiter (2) innerhalb der Isolationszone einen flachen Abschnitt aufweist, der an seinen Stirnseiten jeweils unter Ausbildung eines Übergangsabschnitt (32) in einen zylinderförmigen oder hohlzylinderförmigen Abschnitt (33) übergeht.

11. Elektrischer Verbinder nach einem der vorstehenden Ansprüche, **dadurch gekennzeichnet, dass** die Leiter (2) Kupferleiter sind.

12. Elektrischer Verbinder nach einem der vorstehenden Ansprüche, **dadurch gekennzeichnet, dass** alle Leiter (2) stromführende Leiter sind.

13. Verwendung eines elektrischen Verbinders nach einem der Ansprüche 1 bis 12 zum elektrischen Verbinden von Leiterplatten (21), wobei die Leiterplatten (21) mit ihren Flächenseiten parallel zueinander angeordnet sind.

14. Verwendung nach Anspruch 13, **dadurch gekennzeichnet, dass** alle Leiter (2) des elektrischen Verbinders (1) stromführende Leiter (2) sind.
